# EUROPEAN PATENT SPECIFICATION

(11) **EP 4 080 765 B1**
(45) Date of publication and mention of the grant of the patent: **05.11.2025**
(21) Application number: 20907874.0
(22) Date of filing: 23.12.2020
(51) Int. Cl.: H03F 3/193, H03F 3/45, H03F 3/72, H03H 11/20

(54) **ULTRA-WIDEBAND TWO-BIT PHASE SHIFTER**
ULTRABREITBANDIGER ZWEI-BIT-PHASENSCHIEBER
DÉPHASEUR À DEUX BITS À BANDE ULTRA-LARGE

(30) Priority: 27.12.2019 CN 201911383384
(43) Date of publication of application: 26.10.2022
(73) Proprietor: CETC Guoji Southern Group Co., Ltd., Jiangning District Nanjing, Jiangsu 211153 (CN)
(72) Inventor: LIU, Yao, Nanjing, Jiangsu 211153 (CN); PAN, Xiaofeng, Nanjing, Jiangsu 211153 (CN)
(74) Representative: Maikowski & Ninnemann Patentanwälte Partnerschaft mbB
(86) International application number: PCT/CN2020/138542
(87) International publication number: WO 2021/129646

(56) References cited:
- CN-A- 105 552 485
- CN-A- 107 124 154
- CN-A- 107 863 949
- CN-A- 111 082 765
- CN-U- 203 596 804
- US-A- 4 638 190
- US-A1- 2011 304 409
- US-A1- 2013 033 296
- US-A1- 2016 315 599
- KWANG-JIN KOH ET AL: "A 6-18 GHz 5-bit active phase shifter", MICROWAVE SYMPOSIUM DIGEST (MTT), 2010 IEEE MTT-S INTERNATIONAL, IEEE, PISCATAWAY, NJ, USA, 23 May 2010 (2010-05-23), pages 792 - 795, XP031713407, ISBN: 978-1-4244-6056-4

## Description

### TECHNICAL FIELD

The present disclosure relates to the RF microwave integrated circuit technology of microelectronics and solid state electronics, in particular to an ultra-wideband two-bit phase shifter.

### BACKGROUND

Phase shifter is the key component of modem antenna phased array and microwave communication system, which is used to control the phase change of microwave signal, so as to control the beam scanning of antenna and realize the search and tracking of the target. The volume, phase shifting accuracy, cost, operating temperature and mass production capacity of the phase shifter are directly related to the performance of the whole phased array radar, and the bandwidth of the phase shifter represents the overall bandwidth bottleneck of the transceiver system.

At present, the monolithic integrated phase shifter circuits mainly include transmission line type, reflection type and all-pass network type based on magnetic coupling. Transmission-line-type phase shifters usually have a narrow operating bandwidth. In order to expand the bandwidth, a multi-stage series connection is generally used, which will increase the area of the circuit and increase the insertion loss of the circuit, and the bandwidth is difficult to reach 9 octaves. Reflection-type phase shifters can expand the bandwidth, but are limited by quarter-wavelength lines, and the circuit area is relatively large, which is not conducive to chip miniaturization. Although the operating bandwidth of the all-pass network phase shifter based on magnetic coupling can reach multiple octaves, the phase shifting degree achieved is limited.

The paper "A 6-18 GHz 5-Bit Active Phase Shifter" by Kwang-Jin Koh et. al, published in Mircrowave Symposium Digest (MTT), 2010 IEEE MTT-S International, 23 May 2010, pages 792-795 presents a 6-18 GHz active 5-bit phase shifter in 0.18-µm SiGe BiCMOS technology based on a phase interpolation technique.

According to US 2011/0304409 A1, a phase shifter includes an input terminal; an output terminal; a first signal path; a second signal path; and a switching circuit for selectively connecting one of the first signal path and the second signal path to the input terminal and the output terminal. The first signal path includes a high-pass filter constituting a main path and a low-pass filter secondarily added in parallel to the high-pass filter and constituting a subsidiary path. The low-pass filter compensates for insertion loss caused by the high-pass filter in a frequency range in which a transmission phase difference is given to an RF signal passing through the high-pass filter.

US 2013/033296 A1 describes that a 0-to-90-degree phase shifter includes a voltage-variable power supply, a transistor, a 90-degree divider, gain-variable amplifiers, and a combiner. The 90-degree divider divides an input signal into a signal to which a 90-degree phase is given and a signal to which no phase is given, and outputs the divided signals to the gain-variable amplifier. The gain-variable amplifiers output signals whose amplitudes are changed according to a phase control amount to the combiner. The combiner combines the signals input from the two gain-variable amplifiers and outputs the combined signal. The impedance between the source and the drain of the transistor connected to the isolation port of the 90-degree divider can be changed as appropriate.

US 2016/0315599 A1 describer an active balun circuit that includes a CG transistor having a source terminal thereof connected to an input terminal and a gate terminal thereof grounded, a CS transistor having a gate terminal thereof connected to the input terminal and a source terminal thereof grounded, an asymmetrical transformer, a first output terminal, and a second output terminal. The asymmetrical transformer includes a primary coil and a secondary coil. The primary coil includes a first inductor connected to the CG transistor and a second inductor connected to the CS transistor. The secondary coil includes a third inductor associated with the first inductor and a fourth inductor associated with the second inductor. The first output terminal outputs a first signal generated at the third inductor, and the second output terminal outputs a second signal generated at the fourth inductor.

### SUMMARY

The present disclosure aims to provide an ultra-wideband two-bit phase shifter with high phase shifting accuracy, good amplitude balance, simple control mode and high integration.

The invention is defined by independent claim 1. Features of exemplary embodiments are defined in the dependent claims.

For example, the ninth switching transistor, the eleventh switching transistor, the fourteenth switching transistor, the sixteenth switching transistor, the eighteenth switching transistor and the nineteenth switching transistor as defined in claim 1 are of a same control level; the tenth switching transistor, the twelfth switching transistor, the thirteenth switching transistor, the fifteenth switching transistor, the seventeenth switching transistor and the twentieth switching transistor are of a same control level, which is opposite to the control level of the ninth switching transistor, the eleventh switching transistor, the fourteenth switching transistor, the sixteenth switching transistor, the eighteenth switching transistor and the nineteenth switching transistor.

Additionally, the 180-degree phase shift is realized by turnning on or off the ninth switching transistor to the twentieth switching transistor.

Furthermore, the 90-degree phase shift is realized by turning on or off one of the two branches of the single-pole double-throw switch.

Compared with the prior art, the present invention has beneficial effects as follows: (1) After the single-ended signal is phase-shifted by 180 degrees through active baluns, differential amplification and switch matrix, it enters the RC network to generate the orthogonal signals, and finally are differentially amplified and output by the single-pole double-throw switch to realize the ultra-wideband two-bit phase shifter with the phase shift step of 90 degrees. (2) The phase and amplitude balance is good, the electrical performance is high, the integration is high, the insertion loss is low, the control method is simple and easy to use, and the ultra-wideband two-bit phase shifter can be mass-produced.

### BRIEF DESCRIPTION OF THE DRAWINGS

FIG. 1 illustrates a structural diagram of an ultra-wideband two-bit phase shifter of the present disclosure.
FIG. 2 illustrates a circuit structure diagram of the present disclosure.
FIG. 3 illustrates a circuit structure diagram of the switch matrix of the present disclosure.
FIG. 4 illustrates a circuit structure diagram of a third-order RC orthogonal network of the present disclosure.
FIG. 5 illustrates a circuit layout of a 2-18GHz ultra-wideband two-bit phase shifter according to an embodiment of the present disclosure.
FIG. 6 illustrates a 90-degree phase shift curve of the 2-18GHz ultra-wideband two-bit phase shifter in the embodiment of the present disclosure.
FIG. 7 illustrates a 180-degree phase shift curve of the 2-18GHz ultra-wideband two-bit phase shifter in the embodiment of the present disclosure.
FIG. 8 illustrates a 270-degree phase shift curve of the 2-18GHz ultra-wideband two-bit phase shifter in the embodiment of the present disclosure.
FIG. 9 illustrates an input return loss parameter curve of the 2-18GHz ultra-wideband two-bit phase shifter in the reference state and 90-degree, 180-degree and 270-degree phase shifting states in the embodiment of the present disclosure.
FIG. 10 illustrates an insertion loss parameter curve of the 2-18GHz ultra-wideband two-bit phase shifter in the reference state and 90-degree, 180-degree and 270-degree phase shifting states in the embodiment of the present disclosure.
FIG. 11 illustrates an output return loss parameter curve of the 2-18GHz ultra wideband two bit phase shifter in the reference state and 90-degree, 180-degree and 270-degree phase shifting states in the embodiment of the present disclosure.

### DETAILED DESCRIPTION OF THE EMBODIMENTS

An ultra-wideband two-bit phase shifter of the present disclosure includes an active balun, a first differential amplifier, a second differential amplifier, a third differential amplifier, a switch matrix, an RC orthogonal network and a single-pole double-throw switch. The single-ended signal realizes the differential signal output through the active balun, and then the first differential amplifier circuit conducts waveform shaping and gain compensation. Different branches are selected by the switch matrix to achieve a 180-degree phase shift, and the orthogonal signal is generated by cascading the RC orthogonal network. The subsequent stages are cascaded with the second differential amplifier and the third differential amplifier respectively. Finally, different branches are selected by the single pole double throw switch to generate a 90-degree phase shift stepping amount to achieve 90-degree phase shift amount, 180-degree phase shift amount and 270-degree phase shift amount. The phase shifter has the characteristics of ultra-wideband, high phase-shifting precision, good amplitude balance, simple control method and high integration. The present disclosure will be described in further detail below with reference to the accompanying drawings.

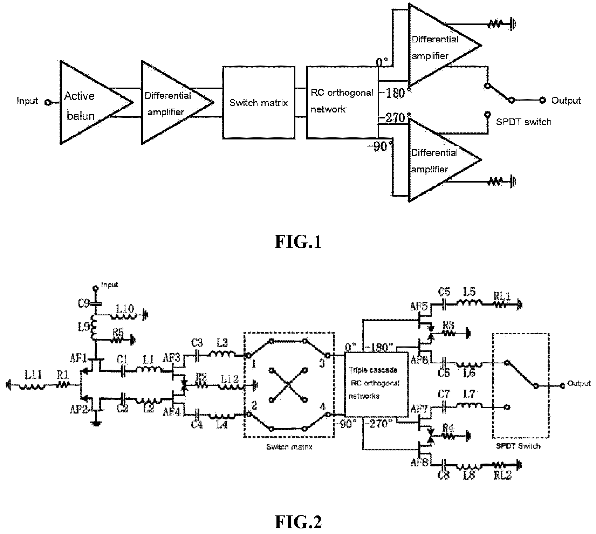

With reference to FIG. 1, the present disclosure provides an ultra-wideband two-bit phase shifter. The ultra-wideband two-bit phase shifter includes an active balun, first to third differential amplifiers, a switch matrix, an RC orthogonal network and a single-pole double-throw switch.

The active balun receives a single-ended signal and converts the single-ended signal into differential signals, two output ports are adopted as an asymmetric structure, and two output signals are respectively connected to two gates of the first differential amplifier.

The first differential amplifier conducts wave shaping and gain compensation on the two received signals, and selects different branches by means of the switch matrix to realize a 180-degree phase shift.

The differential signals generates an two pairs of orthogonal signals through the cascaded RC orthogonal network, and are cascaded to the second and third differential amplifiers respectively.

The single-pole double-throw switch selects different branches of the second and third differential amplifiers to generate a 90-degree phase shift, thereby realizing a 90-degree phase shift, a 180-degree phase shift and a 270-degree phase shift.

With reference to FIG. 2, the single-ended signal is transmitted to the active balun through an input matching network. The input matching network includes a the ninth series capacitor C9, a ninth parallel inductor L9, a tenth series inductor L10 and a fifth parallel resistor R5; the ninth series capacitor C9 and the ninth parallel inductor L9 are connected in series sequentially from an input port to an output port of the input matching network, and a common port of the ninth series capacitor C9 and the ninth parallel inductor L9 is grounded through the tenth series inductor L10; and the output port of the input matching network is grounded through the fifth parallel resistor R5 on one hand, and is connected to an input port of the active balun on the other hand.

As a specific example, the active balun includes an eleventh inductor L11, thea first resistor R1, a first transistor AF1, a second transistor AF2, a first capacitor C1, a second capacitor C2, a first inductor L1 and a second inductor L2.

The sources of the first transistor AF1 and the second transistor AF2 are connected with each other, and a common port of the first transistor and the second transistor is connected with a first resistor R1 and an eleventh inductor L11 in series to the ground; a gate of the first transistor AF1 is connected with the output port of the input matching network, and a gate of the second transistor AF2 is grounded; and a drain of the first transistor AF1 is connected with the first capacitor C1 and the first inductor L1 in series, to serve as a first differential output port of the active balun, and a drain of the second transistor AF2 is connected with the second capacitor C2 and the second inductor L2 in series respectively, to serve as a second differential output port of the active balun.

As a specific example, the first differential amplifier includes a third transistor AF3, a fourth transistor AF4, a third capacitor C3, a fourth capacitor C4, a third inductor L3, a fourth inductor L4, a second resistor R2 and a twelfth inductor L12.

The first differential output port of the active balun is connected to a gate of the third transistor AF3 of the first differential amplifier, and the second differential output port is connected to a gate of the fourth transistor AF4 of the first differential amplifier.

A source of the third transistor AF3 is connected with a source of the fourth transistor AF4, and a common port of the third transistor AF3 and the fourth transistor AF4 is connected with the second resistor R2 and the twelfth inductor L12 in series to the ground. A drain of the third transistor AF3 is connected in series with the third resistor C3 and the third inductor L3, to serve as a first differential output port of the first differential amplifier, and a drain of the fourth transistor AF4 is connected in series with the fourth resistor C4 and the fourth inductor L4, to serve as a second differential output port of the first differential amplifier.

As a specific example, the switch matrix includes a ninth switching transistor AF9 to a twentieth switching transistor AF20, where the ninth switching transistor AF9 to the twelfth switching transistor AF12 are connected in series in sequence, and the thirteenth switching transistor AF13 to the sixteenth switching transistor AF16 are connected in series in sequence.

A common port of the ninth switching transistor AF9 and the tenth switching transistor AF10 is connected to one port of the seventeenth switching transistor AF17 through a microstrip, another port of the seventeenth switching transistor AF17 serves as a first output port of the switch matrix and is connected to one port of the eighteenth switching transistor AF18, and another port of the eighteenth switching transistor AF18 is connected to a common port of the thirteenth switching transistor AF13 and the fourteenth switching transistor AF14 through a microstrip; a common port of the fifteenth switching transistor AF15 and the sixteenth switching transistor AF16 is connected to one port of the twentieth switching transistor AF20 through a microstrip, another port of the twentieth switching transistor AF20 serves as a second output port of the switch matrix and is connected to one port of the nineteenth switching transistor AF19, and another port of the nineteenth switching transistor AF19 is connected to a common port of the eleventh switching transistor AF11 and the twelfth switching transistor AF12 through a microstrip; the first differential output port of the first differential amplifier is connected to a common port of the tenth switching transistor AF10 and the eleventh switching transistor AF11, and the second differential output port of the first differential amplifier is connected to a common port of the fourteenth switching transistor AF14 and the fifteenth switching transistor AF15.

As a specific example, the second differential amplifier includes a fifth transistor AF5, a sixth transistor AF6, a fifth resistor C5, a sixth resistor C6, a fifth inductor L5, a sixth inductor L6 and a third resistor R3. The third differential amplifier includes a seventh transistor AF7, an eighth transistor AF8, a seventh resistor C7, an eighth resistor C8, a seventh inductor L7, an eighth inductor L8 and a fourth resistor R4.

A phase reference port and a -180-degree port of the RC orthogonal network are respectively connected to gates of the fifth transistor AF5 and the sixth transistor AF6 of the second differential amplifier; a 270-degree end and a -90-degree end of the RC orthogonal network are respectively connected to gates of the seventh transistor AF7 and the eighth transistor AF8 of the second differential amplifier.

A source of the fifth transistor AF5 and a source of the sixth transistor AF6 are connected with each other, and a common port of the fifth transistor AF5 and the sixth transistor AF6 is connected with a third resistor R3 in series to the ground; a drain of the fifth transistor AF5 is connected in series with the fifth resistor C5 and the fifth inductor L5, to serve as a first differential output port of the second differential amplifier, and a drain of the sixth transistor AF6 is connected with the sixth resistor C6 and the sixth inductor L6 in series, to serve as a second differential output port of the second differential amplifier; the first differential output port of the second differential amplifier is connected to a first 50-ohm load RL1, and the second differential output port of the second differential amplifier is connected to a branch of a subsequent-stage single-pole double-throw switch.

A source of the seventh transistor AF7 and a source of the eighth transistor AF8 are connected with each other, and a common port of the seventh transistor AF7 and the eighth transistor AF8 is connected with a fourth resistor R4 in series to the ground; a drain of the seventh transistor AF7 is connected in series with the seventh resistor C7 and the seventh inductor L7, to serve as a second differential output port of the third differential amplifier, a drain of the eighth transistor AF8 is connected in series with the eighth resistor C8 and the eighth inductor L8, to serve as a first differential output port of the third differential amplifier, and the first differential output port of the third differential amplifier is connected to a second 50-ohm load RL2, and the second differential output port of the third differential amplifier is connected to another branch of the subsequent-stage single-pole double-throw switch.

As a specific example, the ninth switching transistor AF9, the eleventh switching transistor AF11, the fourteenth switching transistor AF14, the sixteenth switching transistor AF16, the eighteenth switching transistor AF18 and the nineteenth switching transistor AF19 are of a same control level; the tenth switching transistor AF10, the twelfth switching transistor AF12, the thirteenth switching transistor AF13, the fifteenth switching transistor AF15, the seventeenth switching transistor AF17 and the twentieth switching transistor AF20 are of a same control level, which is opposite to the control level of the ninth switching transistor AF9, the eleventh switching transistor AF11, the fourteenth switching transistor AF14, the sixteenth switching transistor AF16, the eighteenth switching transistor AF18 and the nineteenth switching transistor AF19.

Furthermore, the 180-degree phase shift is realized by controlling turn-ons and turn-offs of the ninth switching transistor to the twentieth switching transistor (AF9 to AF20).

Moreover, the 90-degree phase shift is realized by controlling turn-ons and turn-offs of the two branches of the single-pole double-throw switch.

The present disclosure will be described in further detail below in combination with specific embodiments.

### Embodiment

The embodiment is an ultra-wideband two-bit phase shifter operating at 2-18 GHz. the circuit block diagram of which is as illustrated in FIG. 1. The phase shifter includes the active balun, first to third differential amplifier circuits, the switch matrix, RC orthogonal network and single-pole double-throw switch.

The active balun realizes the conversion of the signal from single-ended to differential, in which the drains of transistors AF1 and AF2 are directly biased with resistors, and two output ports are adopted as an asymmetric structure to improve their balance. As illustrated in FIG. 2, the capacitor C1 and the inductor L1 are connected in series with the drain of AF1, and the capacitor C2 and the inductor L2 are connected in series with the drain of AF2. The sources of AF1 and AF2 are connected with each other, and the resistor R1 and the inductor L0 are connected in series between AF1 and AF2 to the ground, and to realize the self-biasing of the differential transistor and the improvement of the differential performance of the active balun.

In order to conduct waveform shaping and gain compensation on the output signal, the two signal output ports of the active balun are respectively connected to the gates of the differential amplifier, such as the gates of transistors AF3 and AF4 in FIG. 2. The drains of AF3 and AF4 are also directly biased by resistor, and the source is connected in series with the resistor R2 and the inductor L0 to the ground to realize the self-biasing and better differential performance. The output port adopts the series structure of capacitor C3 and inductor L3 to realize broadband output matching.

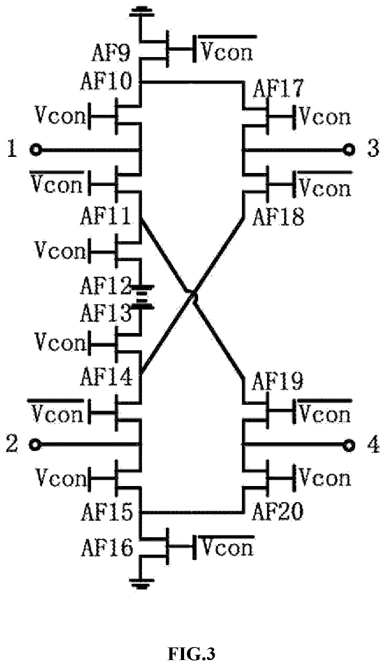

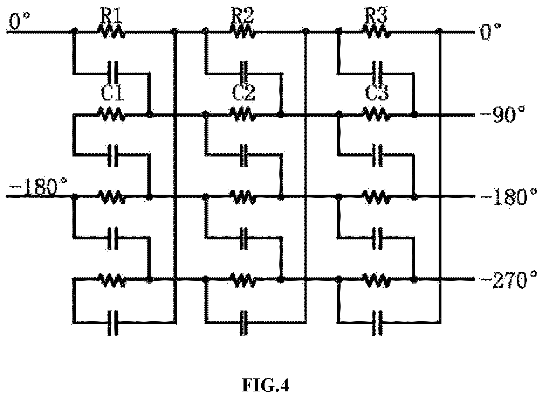

After the single-ended signal passes through the active balun and differential amplifier, a pair of differential signals with ideal amplitude balance and phase balance are obtained. To achieve the 180-degree phase shift, the switch matrix as shown in Fig. 3 is designed. Among them, the switching transistor is equivalent to a small resistor when it is turned on, and it is equivalent to a small capacitor when it is turned off. When Vcon is a high level and V̅c̅o̅n̅ is a low level, the signal goes from port 1 to port 3 via AF10 and AF17, and the other signal goes from port 2 to port 4 via AF15 and AF20; when Vcon is a low level and V̅c̅o̅n̅ is a high level, the signal goes from port 1 to port 4 via AF11 and AF19, and the other signal goes from port 2 to port 3 via AF14 and AF18. Therefore, by the synchronous control of Vcon and V̅c̅o̅n̅, the exchange of signal paths is realized, thereby realizing 180-degree phase shift.
After the 180-degree phase shift is achieved, the differential signal enters the third-order RC orthogonal network cascaded at the subsequent stage to generate four orthogonal signal outputs, which is as illustrated in FIG. 4. Among them, the 0-degree and -180-degree ports are connected to the gates of AF5 and AF6, respectively; the -90-degree and -270-degree ports are connected to the gates of AF8 and AF7, respectively. The subsequent stage differential amplifier is composed of AF5, AF6, C4, L4 and R3, and another subsequent stage differential amplifier is composed of AF8, AF7, C4, L4 and R3. One of the two output ports of the differential amplifier is connected to the load impedance, and the other port is connected to the subsequent stage single-pole double-throw switch. The 90-degree phase shift can be realized by selecting the two branches of the single-pole double-throw switch, and then the 90-degree, 180-degree and 270-degree phase shift can be realized by the joint control of the switch matrix and the single-pole double-throw switch.

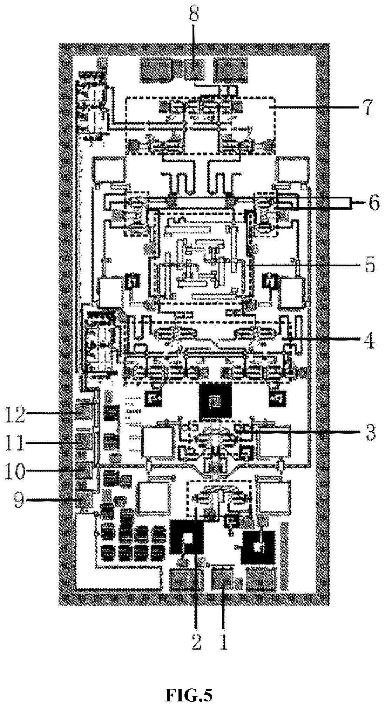

The circuit layout of the 2-18GHz ultra-wideband two-bit phase shifter of the present disclosure is as illustrated in FIG. 5, and the layout is mainly composed of GaAs PHEMT transistors, microstrip lines, resistors, capacitors, ground holes, DC bias ports, and radio frequency ports. The single-ended signal enters from the input port 1, is converted into a differential signal to be output through the active balun 2, and then enters the differential amplifier circuit 3 through the matching network, after amplifying, the signal enters the switch matrix 4 with dual input and dual output to realize 180-degree phase shift of the signal, and then the differential signal is injected into the RC network 5 at the subsequent stage to generate two pairs of orthogonal signals, and the two pairs of signals enter the differential amplifier 6 for waveform shaping and amplification, and then select the path by the single-pole double-throw switch 7 to achieve 90-degree, 180-degree and 270-degree phase shift, and finally are output from signal output port 8. The first port 9, the second port 10, the third port 11 and the fourth port 12 are the DC bias and logic control ports of the circuit.

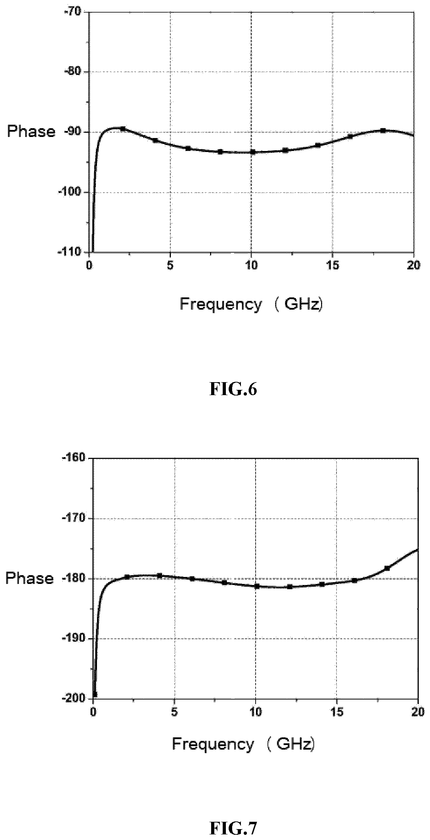

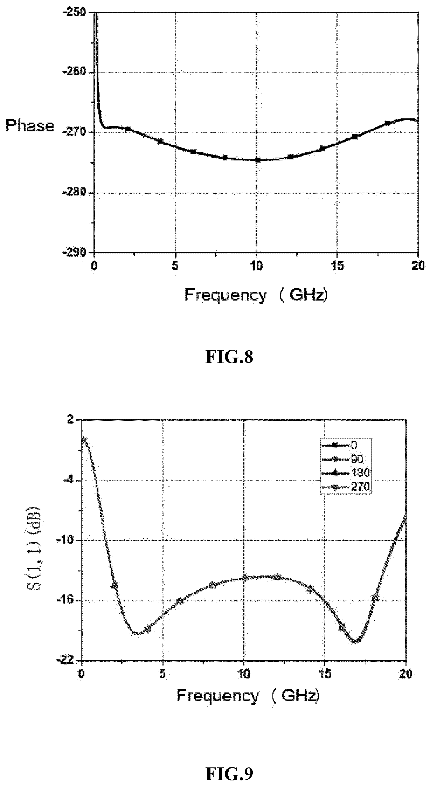

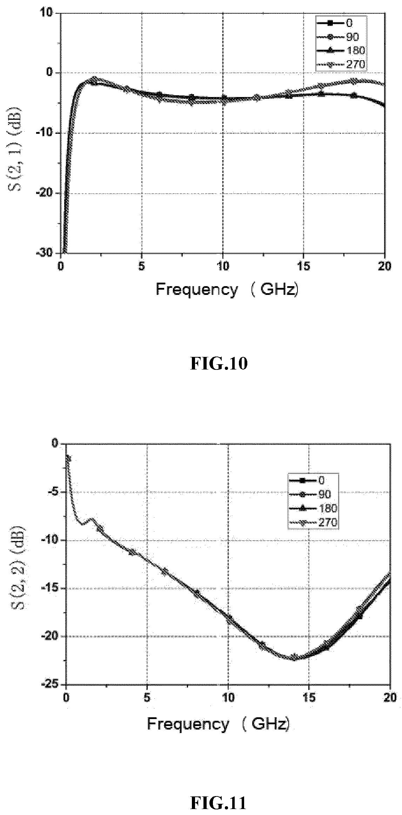

FIGS. 6 to 11 illustrate measured results of the 2-18GHz ultra-wideband two-bit phase shifter of the present disclosure, FIG 6 illustrates a curve of the 90-degree phase shift, FIG. 7 illustrates a curve of the 180-degree phase shift, and FIG. 8 illustrates a curve of the 270-degree phase shift, and FIGS. 9 to 11 illustrate S-parameter curves of the reference state and each of the phase-shifting states. It can be seen from the figures that in the frequency band of 2-18GHz, the phase-shifting accuracy of each of the phase-shifting states in this phase-shifter chip is less than 5 degrees, which has the advantages of small signal loss, high phase-shifting accuracy and large operating bandwidth.

## Claims

1. An ultra-wideband two-bit phase shifter, **characterized by** comprising an active balun, first to third differential amplifiers, a switch matrix, an RC orthogonal network and a single-pole double-throw switch, wherein:
the active balun receives a single-ended (Input)
and converts the single-ended signal into a pair of differential signals, two output ports of the balun are adopted as an asymmetric structure, and two output signals are respectively received at two input ports of the first differential amplifier (AF3, AF4, C3, C4, L3, L4, R2 LI2) the first differential amplifier conducts wave shaping and gain compensation on the two received signals generating a pair of amplified differential signals, different branches are selected by means of the switch matrix to realize a 180-degree phase shift;
two pairs of orthogonal signals are generated by the RC orthogonal network subjected with the amplified differential signals through the selected branches, and wherein respective signals of each of the two pairs of orthogonal signals are cascaded to the second (AF5, AF6, C5, C6, L5, L6 R3) and third (AF7, AF8, C7, C8, L7, L8 R4) differential amplifiers the single-pole double-throw switch selects different branches of the second and third differential amplifiers, thereby realizing a 90-degree phase shift, a 180-degree phase shift and a 270-degree phase shift;
the single-ended signal is transmitted to the active balun through an input matching network;
the input matching network comprises a ninth series capacitor (C9), a ninth inductor (L9), a tenth inductor (L10) and a fifth parallel resistor (R5); the ninth series capacitor (C9) and the ninth inductor (L9) are connected in series sequentially from an input port to an output port of the input matching network, and a common port of the ninth series capacitor (C9) and the ninth inductor (L9) is grounded through the tenth inductor (L10); and the output port of the input matching network is grounded through the fifth parallel resistor (R5) on one hand, and is connected to an input port of the active balun on the other hand;
the active balun comprises an eleventh inductor (L11), a first resistor (R1), a first transistor (AF1), a second transistor (AF2), a first capacitor (C1), a second capacitor (C2), a first inductor (L1) and a second inductor (L2);
sources of the first transistor (AF1) and the second transistor (AF2) are connected with each other at a common port of the first transistor (AF1) and the second transistor (AF2) being connected with a first resistor (R1) and an eleventh inductor (L11) in series to the ground; a gate of the first transistor (AF1) is connected with the output port of the input matching network, and a gate of the second transistor (AF2) is grounded; and a drain of the first transistor (AF1) is connected with the first capacitor (C1) and the first inductor (L1) in series to a first differential output port of the active balun, and a drain of the second transistor (AF2) is connected with the second capacitor (C2) and the second inductor (L2) in series to a second differential output port of the active balun;
the first differential amplifier comprises a third transistor (AF3), a fourth transistor (AF4), a third capacitor (C3), a fourth capacitor (C4), a third inductor (L3), a fourth inductor (L4), a second resistor (R2) and a twelfth inductor (L12);
the first differential output port of the active balun is connected to a gate of the third transistor (AF3) of the first differential amplifier, and the second differential output port is connected to a gate of the fourth transistor (AF4) of the first differential amplifier;
a source of the third transistor (AF3) is connected with a source of the fourth transistor (AF4), and a common port of the third transistor (AF3) and the fourth transistor (AF4) is connected with the second resistor (R2) and the twelfth inductor (L12) in series to the ground; and a drain of the third transistor (AF3) is connected in series with the third capacitor (C3) and the third inductor (L3) to a first differential output port of the first differential amplifier, and a drain of the fourth transistor (AF4) is connected in series with the fourth capacitor (C4) and the fourth inductor (L4) to a second differential output port of the first differential amplifier;
the switch matrix comprises a ninth switching transistor (AF9) to a twentieth switching transistor (AF20), wherein the ninth switching transistor (AF9) to the twelfth switching transistor (AF12) are connected in series in sequence, and the thirteenth switching transistor (AF13) to the sixteenth switching transistor (AF16) are connected in series in sequence;
a common port of the ninth switching transistor (AF9) and the tenth switching transistor (AF10) is connected to one port of the seventeenth switching transistor (AF17) through a microstrip, another port of the seventeenth switching transistor (AF17) serves as a first output port of the switch matrix and is connected to one port of the eighteenth switching transistor (AF18), and another port of the eighteenth switching transistor (AF18) is connected to a common port of the thirteenth switching transistor (AF13) and the fourteenth switching transistor (AF14) through a microstrip;
the common port of the fifteenth switching transistor (AF15) and the sixteenth switching transistor (AF16) is connected to one port of the twentieth switching transistor (AF20) through a microstrip, another port of the twentieth switching transistor (AF20) serves as a second output port of the switch matrix and is connected to one port of the nineteenth switching transistor (AF19), and another port of the nineteenth switching transistor (AF19) is connected to a common port of the eleventh switching transistor (AF11) and the twelfth switching transistor (AF12) through a microstrip; and the first differential output port of the first differential amplifier is connected to a common port of the tenth switching transistor (AF10) and the eleventh switching transistor (AF11), and the second differential output port of the first differential amplifier is connected to a common port of the fourteenth switching transistor (AF14) and the fifteenth switching transistor (AF15);
the second differential amplifier comprises a fifth transistor (AF5), a sixth transistor (AF6), a fifth capacitor (C5), a sixth capacitor (C6), a fifth inductor (L5), a sixth inductor (L6) and a third resistor (R3); the third differential amplifier comprises a seventh transistor (AF7), an eighth transistor (AF8), a seventh capacitor (C7), an eighth capacitor (C8), a seventh inductor (L7), an eighth inductor (L8) and a fourth resistor (R4);
a phase reference port and a 180-degree port of the RC orthogonal network are respectively connected to gates of the fifth transistor (AF5) and the sixth transistor (AF6) of the second differential amplifier; a 270-degree port and a 90-degree port of the RC orthogonal network are respectively connected to gates of the seventh transistor (AF7) and the eighth transistor (AF8) of the second differential amplifier;
a source of the fifth transistor (AF5) and a source of the sixth transistor (AF6) are connected with each other, and a common port of the fifth transistor (AF5) and the sixth transistor (AF6) is connected with a third resistor (R3) in series to the ground; the drain of the fifth transistor (AF5) is connected in series with the fifth capacitor (C5) and the fifth inductor (L5), to serve as a first differential output port of the second differential amplifier, and a drain of the sixth transistor (AF6) is connected with the sixth capacitor (C6) and the sixth inductor (L6) in series, to serve as a second differential output port of the second differential amplifier; the first differential output port of the second differential amplifier is connected to a first 50-ohm load (RL1), and the second differential output port of the second differential amplifier is connected to a branch of a subsequent-stage single-pole double-throw switch;
a source of the seventh transistor (AF7) and a source of the eighth transistor (AF8) are connected with each other, and a common port of the seventh transistor (AF7) and the eighth transistor (AF8) is connected with a fourth resistor (R4) in series to the ground;
a drain of the seventh transistor (AF7) is connected in series with the seventh capacitor (C7) and the seventh inductor (L7), to serve as a second differential output port of the third differential amplifier, a drain of the eighth transistor (AF8) is connected in series with the eighth capacitor (C8) and the eighth inductor (L8), to serve as a first differential output terminal port of the third differential amplifier, and the first differential output port of the third differential amplifier is connected to a second 50-ohm load (RL2), and the second differential output port of the third differential amplifier is connected to another branch of the subsequent-stage single-pole double-throw switch.

2. The ultra-wideband two-bit phase shifter according to claim 1, wherein the ninth switching transistor (AF9), the eleventh switching transistor (AF11), the fourteenth switching transistor (AF14), the sixteenth switching transistor (AF16), the eighteenth switching transistor (AF18) and the nineteenth switching transistor (AF19) are of a same control level; the tenth switching transistor (AF10), the twelfth switching transistor (AF12), the thirteenth switching transistor (AF13), the fifteenth switching transistor (AF15), the seventeenth switching transistor (AF17) and the twentieth switching transistor (AF20) are of a same control level, which is opposite to the control level of the ninth switching transistor (AF9), the eleventh switching transistor (AF11), the fourteenth switching transistor (AF14), the sixteenth switching transistor (AF16), the eighteenth switching transistor (AF18) and the nineteenth switching transistor (AF19).

3. The ultra-wideband two-bit phase shifter according to claim 2, wherein the 180-degree phase shift is realized by turning on or off the ninth switching transistor to the twentieth switching transistors (AF9 to AF20) .

4. The ultra-wideband two-bit phase shifter according to claim 2 or 3, wherein the 90-degree phase shift is realized by turning on or off one of the two branches of the single-pole double-throw switch.

## Patentansprüche

1. Ultrabreitband-Zweibitphasenschieber,
**gekennzeichnet durch** ein aktives Balun, erste bis dritte Differenzverstärker, eine Schaltmatrix, ein orthogonales RC-Netzwerk und einen einpoligen Wechselschalter, wobei das aktive Balun einen Eintakt (Eingabe) empfängt und das Eintaktsignal in ein Paar differentieller Signale umwandelt, wobei zwei Ausgangsanschlüsse des Baluns als eine asymmetrische Struktur angewendet werden und zwei Ausgangssignale jeweils bei zwei Eingangsanschlüssen des ersten Differenzverstärkers (AF3, AF4, C3, C4, L3, L4, R2 LI2) empfangen werden,
der erste Differenzverstärker ein Wellenformen und einen Verstärkungsausgleich an den zwei Empfangssignalen durchführt, was ein Paar verstärkter differentieller Signale erzeugt, wobei verschiedene Zweige mittels der Schaltmatrix gewählt werden, um einen 180 Grad-Phasenversatz zu realisieren;
zwei Paare orthogonaler Signale durch das orthogonale RC-Netzwerk erzeugt werden, dem die verstärkten differentiellen Signalen durch die gewählten Zweige ausgesetzt werden, und wobei jeweilige Signale jedes der zwei Paare orthogonaler Signale zu dem zweiten (AF5, AF6, C5, C6, L5, L6 R3) und dem dritten (AF7, AF8, C7, C8, L7, L8 R4) Differenzverstärker kaskadiert werden,
der einpolige Wechselschalter verschiedene Zweige des zweiten und der dritten Differenzverstärkers wählt, wodurch ein 90 Grad-Phasenversatz, ein 180 Grad-Phasenversatz und ein 270 Grad-Phasenversatz realisiert werden;
das Eintaktsignal durch ein Eingangsabgleichnetzwerk zum aktiven Balun übertragen wird;
das Eingangsabgleichnetzwerk einen neunten Reihenkondensator (C9), eine neunte Induktivität (L9), eine zehnte Induktivität (L10) und einen fünften Parallelwiderstand (R5) umfasst; der neunte Reihenkondensator (C9) und die neunte Induktivität (L9) von einem Eingangsanschluss zu einem Ausgangsanschluss des Eingangsabgleichnetzwerks sequenziell in Reihe geschaltet sind und ein gemeinsamer Anschluss des neunten Reihenkondensators (C9) und der neunten Induktivität (L9) über die zehnte Induktivität (L10) geerdet ist; und der Ausgangsanschluss des Eingangsabgleichnetzwerks einerseits über den fünften Parallelwiderstand (R5) geerdet ist und andererseits mit einem Eingangsanschluss des aktiven Baluns verbunden ist;
das aktive Balun eine elfte Induktivität (L11), einen ersten Widerstand (R1), einen ersten Transistor (AF1), einen zweiten Transistor (AF2), einen ersten Kondensator (C1), einen zweiten Kondensator (C2), eine erste Induktivität (L1) und eine zweite Induktivität (L2) umfasst;
Sources des ersten Transistors (AF1) und des zweiten Transistors (AF2) bei einem gemeinsamen Anschluss des ersten Transistors (AF1) und des zweiten Transistors (AF2), der mit einem ersten Widerstand (R1) und einer elften Induktivität (L11) in Reihe mit der Erdung verbunden ist, miteinander verbunden sind; ein Gate des ersten Transistors (AF1) mit dem Ausgangsanschluss des Eingangsabgleichnetzwerks verbunden ist und ein Gate des zweiten Transistors (AF2) geerdet ist; und ein Drain des ersten Transistors (AF1) mit dem ersten Kondensator (C1) und der ersten Induktivität (L1) in Reihe mit einem ersten differentiellen Ausgangsanschluss des aktiven Baluns verbunden ist und ein Drain des zweiten Transistors (AF2) mit dem zweiten Kondensator (C2) und der zweiten Induktivität (L2) in Reihe mit einem zweiten differentiellen Ausgangsanschluss des aktiven Baluns verbunden ist;
der erste Differenzverstärker einen dritten Transistor (AF3), einen vierten Transistor (AF4), einen dritten Kondensator (C3), einen vierten Kondensator (C4), eine dritte Induktivität (L3), eine vierte Induktivität (L4), einen zweiten Widerstand (R2) und eine zwölfte Induktivität (L12) umfasst;
der erste differentielle Ausgangsanschluss des aktiven Baluns mit einem Gate des dritten Transistors (AF3) des ersten Differenzverstärkers verbunden ist und der zweite differentielle Ausgangsanschluss mit einem Gate des vierten Transistors (AF4) des ersten Differenzverstärkers verbunden ist;
eine Source des dritten Transistors (AF3) mit einer Source des vierten Transistors (AF4) verbunden ist und ein gemeinsamer Anschluss des dritten Transistors (AF3) und des vierten Transistors (AF4) mit dem zweiten Widerstand (R2) und der zwölften Induktivität (L12) in Reihe mit der Erdung verbunden ist; und ein Drain des dritten Transistors (AF3) in Reihe mit dem dritten Kondensator (C3) und der dritten Induktivität (L3) mit einem ersten differentiellen Ausgangsanschluss des ersten Differenzverstärkers verbunden ist und ein Drain des vierten Transistors (AF4) in Reihe mit dem vierten Kondensator (C4) und der vierten Induktivität (L4) mit einem zweiten differentiellen Ausgangsanschluss des ersten Differenzverstärkers verbunden ist;
die Schaltmatrix einen neunten Schalttransistor (AF9) bis zu einem zwanzigsten Schalttransistor (AF20) umfasst, wobei der neunte Schalttransistor (AF9) bis zum zwölften Schalttransistor (AF12) sequenziell in Reihe geschaltet sind und der dreizehnte Schalttransistor (AF13) bis zum sechzehnten Schalttransistor (AF16) sequenziell in Reihe geschaltet sind;
ein gemeinsamer Anschluss des neunten Schalttransistors (AF9) und des zehnten Schalttransistors (AF10) mit einem Anschluss des siebzehnten Schalttransistors (AF17) über einen Mikrostreifen verbunden ist, ein weiterer Anschluss des siebzehnten Schalttransistors (AF17) als ein erster Ausgangsanschluss der Schaltmatrix dient und mit einem Anschluss des achtzehnten Schalttransistors (AF18) verbunden ist und ein weiterer Anschluss des achtzehnten Schalttransistors (AF18) mit einem gemeinsamen Anschluss des dreizehnten Schalttransistors (AF13) und des vierzehnten Schalttransistors (AF14) über einen Mikrostreifen verbunden ist;
der gemeinsame Anschluss des fünfzehnten Schalttransistors (AF15) und des sechzehnten Schalttransistors (AF16) mit einem Anschluss des zwanzigsten Schalttransistors (AF20) über einen Mikrostreifen verbunden ist, ein weiterer Anschluss des zwanzigsten Schalttransistors (AF20) als ein zweiter Ausgangsanschluss der Schaltmatrix dient und mit einem Anschluss des neunzehnten Schalttransistors (AF19) verbunden ist und ein weiterer Anschluss des neunzehnten Schalttransistors (AF19) mit einem gemeinsamen Anschluss des elften Schalttransistors (AF11) und des zwölften Schalttransistors (AF12) über einen Mikrostreifen verbunden ist; und der erste differentielle Ausgangsanschluss des ersten Differenzverstärkers mit einem gemeinsamen Anschluss des zehnten Schalttransistors (AF10) und des elften Schalttransistors (AF11) verbunden ist und der zweite differentielle Ausgangsanschluss des ersten Differenzverstärkers mit einem gemeinsamen Anschluss des vierzehnten Schalttransistors (AF14) und des fünfzehnten Schalttransistors (AF15) verbunden ist;
der zweite Differenzverstärker einen fünften Transistor (AF5), einen sechsten Transistor (AF6), einen fünften Kondensator (C5), einen sechsten Kondensator (C6), eine fünfte Induktivität (L5), eine sechste Induktivität (L6) und einen dritten Widerstand (R3) umfasst; der dritte Differenzverstärker einen siebten Transistor (AF7), einen achten Transistor (AF8), einen siebten Kondensator (C7), einen achten Kondensator (C8), eine siebte Induktivität (L7), eine achte Induktivität (L8) und einen vierten Widerstand (R4) umfasst;
ein Phasenbezugsanschluss und ein 180 Grad-Anschluss des orthogonalen RC-Netzwerks mit Gates des fünften Transistors (AF5) bzw. des sechsten Transistors (AF6) des zweiten Differenzverstärkers verbunden sind; ein 270 Grad-Anschluss und ein 90 Grad-Anschluss des orthogonalen RC-Netzwerks mit Gates des siebten Transistors (AF7) bzw. des achten Transistors (AF8) des zweiten Differenzverstärkers verbunden sind;
eine Source des fünften Transistors (AF5) und eine Source des sechsten Transistors (AF6) miteinander verbunden sind und ein gemeinsamer Anschluss des fünften Transistors (AF5) und des sechsten Transistors (AF6) mit einem dritten Widerstand (R3) in Reihe mit der Erdung verbunden ist;
der Drain des fünften Transistors (AF5) mit dem fünften Kondensator (C5) und der fünften Induktivität (L5) in Reihe geschaltet ist, um als ein erster differentieller Ausgangsanschluss des zweiten Differenzverstärkers zu dienen, und ein Drain des sechsten Transistors (AF6) mit dem sechsten Kondensator (C6) und der sechsten Induktivität (L6) in Reihe geschaltet ist, um als ein zweiter differentieller Ausgangsanschluss des zweiten Differenzverstärkers zu dienen; der erste differentielle Ausgangsanschluss des zweiten Differenzverstärkers mit ein ersten 50 Ohm-Last (RL1) verbunden ist und der zweite differentielle Ausgangsanschluss des zweiten Differenzverstärkers mit einem Zweig eines einpoligen Wechselschalters einer nachfolgenden Stufe verbunden ist;
eine Source des siebten Transistors (AF7) und eine Source des achten Transistors (AF8) miteinander verbunden sind und ein gemeinsamer Anschluss des siebten Transistors (AF7) und des achten Transistors (AF8) mit einem vierten Widerstand (R4) in Reihe mit der Erdung verbunden ist; und
ein Drain des siebten Transistors (AF7) in Reihe mit dem siebten Kondensator (C7) und der siebten Induktivität (L7) verbunden ist, um als ein zweiter differentieller Ausgangsanschluss des dritten Differenzverstärkers zu dienen, ein Drain des achten Transistors (AF8) in Reihe mit dem achten Kondensator (C8) und der achten Induktivität (L8) verbunden ist, um als ein erster differentieller Ausgangsanschlussanschluss des dritten Differenzverstärkers zu dienen, und der erste differentielle Ausgangsanschluss des dritten Differenzverstärkers mit einer zweiten 50 Ohm-Last (RL2) verbunden ist und der zweite differentielle Ausgangsanschluss des dritten Differenzverstärkers mit einem weiteren Zweig des einpoligen Wechselschalters einer nachfolgenden Stufe verbunden ist.

2. Ultrabreitband-Zweibitphasenschieber nach Anspruch 1, wobei der neunte Schalttransistor (AF9), der elfte Schalttransistor (AF11), der vierzehnte Schalttransistor (AF14), der sechzehnte Schalttransistor (AF16), der achtzehnte Schalttransistor (AF18) und der neunzehnte Schalttransistor (AF19) vom selben Steuerniveau sind; und der zehnte Schalttransistor (AF10), der zwölfte Schalttransistor (AF12), der dreizehnte Schalttransistor (AF13), der fünfzehnte Schalttransistor (AF15), der siebzehnte Schalttransistor (AF17) und der zwanzigste Schalttransistor (AF20) vom selben Steuerniveau sind, das zum Steuerniveau des neunten Schalttransistors (AF9), des elften Schalttransistors (AF11), des vierzehnten Schalttransistors (AF14), des sechzehnten Schalttransistors (AF16), des achtzehnten Schalttransistors (AF18) und des neunzehnten Schalttransistor (AF19) entgegengesetzt ist.

3. Ultrabreitband-Zweibitphasenschieber nach Anspruch 2, wobei der 180 Grad-Phasenversatz durch Ein- oder Ausschalten der neunten bis zwanzigsten Schalttransistoren (AF9 bis AF20) realisiert wird.

4. Ultrabreitband-Zweibitphasenschieber nach Anspruch 2 oder 3, wobei der 90 Grad-Phasenversatz durch Ein- oder Ausschalten eines der zwei Zweige des einpoligen Wechselschalters realisiert wird.

## Revendications

1. Déphaseur à deux bits à ultra-large bande, **caractérisé en ce qu'**il comprend un balun actif, des premier à troisième amplificateurs différentiels, une matrice de commutation, un réseau orthogonal RC et un commutateur unipolaire à deux directions, dans lequel :
le balun actif reçoit un asymétrique (Input) et convertit le signal asymétrique en une paire de signaux différentiels, deux ports de sortie du balun sont adoptés comme une structure asymétrique, et deux signaux de sortie sont reçus respectivement au niveau de deux ports d'entrée du premier amplificateur différentiel (AF3, AF4, C3, C4, L3, L4, R2, L12)
le premier amplificateur différentiel effectue une mise en forme d'onde et une compensation de gain sur les deux signaux reçus, générant une paire de signaux différentiels amplifiés, des branches différentes étant sélectionnées au moyen de la matrice de commutation pour réaliser un déphasage de 180 degrés ;
deux paires de signaux orthogonaux sont générées par le réseau orthogonal RC soumis aux signaux différentiels amplifiés à travers les branches sélectionnées, et les signaux respectifs de chacune des deux paires de signaux orthogonaux sont mis en cascade vers les deuxième (AF5, AF6, C5, C6, L5, L6, R3) et troisième (AF7, AF8, C7, C8, L7, L8, R4) amplificateurs différentiels
le commutateur unipolaire à deux directions sélectionne des branches différentes des deuxième et troisième amplificateurs différentiels, réalisant ainsi un déphasage de 90 degrés, un déphasage de 180 degrés et un déphasage de 270 degrés ;
le signal asymétrique est transmis au balun actif à travers un réseau d'adaptation d'entrée ;
le réseau d'adaptation d'entrée comprend un neuvième condensateur en série (C9), une neuvième inductance (L9), une dixième inductance (L10) et une cinquième résistance en parallèle (R5) ; le neuvième condensateur en série (C9) et la neuvième inductance (L9) sont connectés en série de manière séquentielle entre un port d'entrée et un port de sortie du réseau d'adaptation d'entrée, et un port commun du neuvième condensateur en série (C9) et de la neuvième inductance (L9) est mis à la masse à travers la dixième inductance (L10) ; et le port de sortie du réseau d'adaptation d'entrée est mis à la masse à travers la cinquième résistance en parallèle (R5) d'une part, et est connecté à un port d'entrée du balun actif d'autre part ;
le balun actif comprend une onzième inductance (L11), une première résistance (R1), un premier transistor (AF1), un deuxième transistor (AF2), un premier condensateur (C1), un deuxième condensateur (C2), une première inductance (L1) et une deuxième inductance (L2) ;
les sources du premier transistor (AF1) et du deuxième transistor (AF2) sont connectées entre elles au niveau d'un port commun du premier transistor (AF1) et du deuxième transistor (AF2) qui est connecté à une première résistance (R1) et à une onzième inductance (L11) en série avec la masse ; la grille du premier transistor (AF1) est connectée au port de sortie du réseau d'adaptation d'entrée, et la grille du deuxième transistor (AF2) est mise à la masse ; et le drain du premier transistor (AF1) est connecté au premier condensateur (C1) et à la première inductance (L1) en série avec un premier port de sortie différentiel du balun actif, et le drain du deuxième transistor (AF2) est connecté au deuxième condensateur (C2) et à la deuxième inductance (L2) en série avec un deuxième port de sortie différentiel du balun actif ;
le premier amplificateur différentiel comprend un troisième transistor (AF3), un quatrième transistor (AF4), un troisième condensateur (C3), un quatrième condensateur (C4), une troisième inductance (L3), une quatrième inductance (L4), une deuxième résistance (R2) et une douzième inductance (L12) ;
le premier port de sortie différentiel du balun actif est connecté à la grille du troisième transistor (AF3) du premier amplificateur différentiel, et le deuxième port de sortie différentiel est connecté à la grille du quatrième transistor (AF4) du premier amplificateur différentiel ;
la source du troisième transistor (AF3) est connectée à la source du quatrième transistor (AF4), et un port commun du troisième transistor (AF3) et du quatrième transistor (AF4) est connecté à la deuxième résistance (R2) et à la douzième inductance (L12) en série avec la masse ; le drain du troisième transistor (AF3) est connecté en série avec le troisième condensateur (C3) et la troisième inductance (L3) à un premier port de sortie différentiel du premier amplificateur différentiel, et le drain du quatrième transistor (AF4) est connecté en série avec le quatrième condensateur (C4) et la quatrième inductance (L4) à un deuxième port de sortie différentiel du premier amplificateur différentiel ;
la matrice de commutation comprend un neuvième transistor de commutation (AF9) jusqu'à un vingtième transistor de commutation (AF20), le neuvième transistor de commutation (AF9) jusqu'au douzième transistor de commutation (AF12) sont connectés en série de manière séquentielle, et le treizième transistor de commutation (AF13) jusqu'au seizième transistor de commutation (AF16) sont connectés en série de manière séquentielle ;
un port commun du neuvième transistor de commutation (AF9) et du dixième transistor de commutation (AF10) est connecté à un port du dix-septième transistor de commutation (AF17) à travers un microruban, un autre port du dix-septième transistor de commutation (AF17) sert de premier port de sortie de la matrice de commutation et est connecté à un port du dix-huitième transistor de commutation (AF18), et un autre port du dix-huitième transistor de commutation (AF18) est connecté à un port commun du treizième transistor de commutation (AF13) et du quatorzième transistor de commutation (AF14) à travers un microruban ;
le port commun du quinzième transistor de commutation (AF15) et du seizième transistor de commutation (AF16) est connecté à un port du vingtième transistor de commutation (AF20) à travers un microruban, un autre port du vingtième transistor de commutation (AF20) sert de deuxième port de sortie de la matrice de commutation et est connecté à un port du dix-neuvième transistor de commutation (AF19), et un autre port du dix-neuvième transistor de commutation (AF19) est connecté à un port commun du onzième transistor de commutation (AF11) et du douzième transistor de commutation (AF12) à travers un microruban ; et le premier port de sortie différentiel du premier amplificateur différentiel est connecté à un port commun du dixième transistor de commutation (AF10) et du onzième transistor de commutation (AF11), et le deuxième port de sortie différentiel du premier amplificateur différentiel est connecté à un port commun du quatorzième transistor de commutation (AF14) et du quinzième transistor de commutation (AF15) ;
le deuxième amplificateur différentiel comprend un cinquième transistor (AF5), un sixième transistor (AF6), un cinquième condensateur (C5), un sixième condensateur (C6), une cinquième inductance (L5), une sixième inductance (L6) et une troisième résistance (R3) ; le troisième amplificateur différentiel comprend un septième transistor (AF7), un huitième transistor (AF8), un septième condensateur (C7), un huitième condensateur (C8), une septième inductance (L7), une huitième inductance (L8) et une quatrième résistance (R4) ;
un port de référence de phase et un port à 180 degrés du réseau orthogonal RC sont respectivement connectés aux grilles du cinquième transistor (AF5) et du sixième transistor (AF6) du deuxième amplificateur différentiel ; un port à 270 degrés et un port à 90 degrés du réseau orthogonal RC sont respectivement connectés aux grilles du septième transistor (AF7) et du huitième transistor (AF8) du deuxième amplificateur différentiel ;
la source du cinquième transistor (AF5) et la source du sixième transistor (AF6) sont connectées entre elles, et un port commun du cinquième transistor (AF5) et du sixième transistor (AF6) est connecté à une troisième résistance (R3) en série avec la masse ;
le drain du cinquième transistor (AF5) est connecté en série avec le cinquième condensateur (C5) et la cinquième inductance (L5), pour servir de premier port de sortie différentiel du deuxième amplificateur différentiel, et le drain du sixième transistor (AF6) est connecté en série avec le sixième condensateur (C6) et la sixième inductance (L6), pour servir de deuxième port de sortie différentiel du deuxième amplificateur différentiel ; le premier port de sortie différentiel du deuxième amplificateur différentiel est connecté à une première charge de 50 ohms (RL1), et le deuxième port de sortie différentiel du deuxième amplificateur différentiel est connecté à une branche d'un commutateur unipolaire à deux directions de l'étage suivant ;
la source du septième transistor (AF7) et la source du huitième transistor (AF8) sont connectées entre elles, et un port commun du septième transistor (AF7) et du huitième transistor (AF8) est connecté à une quatrième résistance (R4) en série avec la masse ;
le drain du septième transistor (AF7) est connecté en série avec le septième condensateur (C7) et la septième inductance (L7), pour servir de deuxième port de sortie différentiel du troisième amplificateur différentiel, le drain du huitième transistor (AF8) est connecté en série avec le huitième condensateur (C8) et la huitième inductance (L8), pour servir de premier port de borne de sortie différentiel du troisième amplificateur différentiel, et le premier port de sortie différentiel du troisième amplificateur différentiel est connecté à une deuxième charge de 50 ohms (RL2), et le deuxième port de sortie différentiel du troisième amplificateur différentiel est connecté à une autre branche du commutateur unipolaire à deux directions de l'étage suivant.

2. Déphaseur à deux bits à ultra-large bande selon la revendication 1, dans lequel le neuvième transistor de commutation (AF9), le onzième transistor de commutation (AF11), le quatorzième transistor de commutation (AF14), le seizième transistor de commutation (AF16), le dix-huitième transistor de commutation (AF18) et le dix-neuvième transistor de commutation (AF19) appartiennent à un même niveau de commande ; le dixième transistor de commutation (AF10), le douzième transistor de commutation (AF12), le treizième transistor de commutation (AF13), le quinzième transistor de commutation (AF15), le dix-septième transistor de commutation (AF17) et le vingtième transistor de commutation (AF20) appartiennent à un même niveau de commande, opposé au niveau de commande du neuvième transistor de commutation (AF9), du onzième transistor de commutation (AF11), du quatorzième transistor de commutation (AF14), du seizième transistor de commutation (AF16), du dix-huitième transistor de commutation (AF18) et du dix-neuvième transistor de commutation (AF19).

3. Déphaseur à deux bits à ultra-large bande selon la revendication 2, dans lequel le déphasage de 180 degrés est réalisé par mise en conduction ou blocage du neuvième transistor de commutation jusqu'au vingtième transistor de commutation (AF9 à AF20).

4. Déphaseur à deux bits à ultra-large bande selon la revendication 2 ou 3, dans lequel le déphasage de 90 degrés est réalisé par fermeture ou ouverture de l'une des deux branches du commutateur unipolaire à deux directions.
